(19) Europäisches Patentamt
European Patent Office
Office européen des brevets

(11) EP 3 881 989 A1

(12) EUROPEAN PATENT APPLICATION
published in accordance with Art. 153(4) EPC

(43) Date of publication:
22.09.2021 Bulletin 2021/38

(51) Int Cl.:
B25J 19/06 (2006.01)    G01M 13/02 (2019.01)
G01R 31/34 (2020.01)

(21) Application number: 19884734.5

(22) Date of filing: 12.11.2019

(86) International application number:
PCT/JP2019/044377

(87) International publication number:
WO 2020/100909 (22.05.2020 Gazette 2020/21)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 13.11.2018 JP 2018213145

(71) Applicant: Kawasaki Jukogyo Kabushiki Kaisha
Hyogo 650-8670 (JP)

(72) Inventors:
• KATO, Yuki
  650-8670 Hyogo (JP)
• SATO, Eiji
  650-8670 Hyogo (JP)
• TAGUCHI, Tetsuya
  650-8670 Hyogo (JP)
• KITAMURA, Shinji
  650-8670 Hyogo (JP)
• KAWAI, Makoto
  650-8670 Hyogo (JP)
(74) Representative: Witte, Weller & Partner
Patentanwälte mbB
Postfach 10 54 62
70047 Stuttgart (DE)

(54) FAULT DIAGNOSIS DEVICE FOR DRIVE MECHANISM, FAULT DIAGNOSIS METHOD, AND MECHANICAL APPARATUS PROVIDED WITH FAULT DIAGNOSIS DEVICE

(57) A failure diagnosing device of a drive mechanism of the present disclosure is a failure diagnosing device configured to diagnose a failure of a drive mechanism (51) of a mechanical apparatus (11) provided with a body (31) including a motor (14), a speed reducer (13) configured to slow down rotational power of the motor (14), and an operation part (12) configured to operate by the rotational power slowed down by the speed reducer (13), and a vibration-proof controller (33) configured to perform a vibration-proof control to prevent vibration of the body (31), the drive mechanism (51) including the speed reducer (13) and the motor (14). The failure diagnosing device sends a command for suspending the vibration-proof control to the vibration-proof controller (33) of the mechanical apparatus (11), then identifies an acceleration-and-deceleration period during which operation of the mechanical apparatus (11) of which the vibration-proof control is suspended accelerates and decelerates, and determines whether the drive mechanism (51) indicates a sign of failure based on a change in a frequency spectrum of load current of the motor (14) or a current value having a correlation with the load current to a change in a rotational speed of the motor (14) during the acceleration-and-deceleration period.

FIG. 1

**Description**

TECHNICAL FIELD

The present disclosure relates to a failure diagnosing device of a drive mechanism, a method of diagnosing a failure, and a mechanical apparatus provided with the failure diagnosing device.

BACKGROUND ART

Conventionally, a method of diagnosing a failure of a speed reducer is known, which determines whether there is a sign of failure in the speed reducer based on a change in frequency spectra of motor current with respect to a change in a rotational speed of a motor during an acceleration-and-deceleration period of a mechanical apparatus (refer to Patent Document 1). Since this failure diagnosing method performs the failure diagnosis during the acceleration-and-deceleration period of the mechanical apparatus, it can perform the failure diagnosis during a work of the mechanical apparatus.

[Reference Document of Conventional Art]

[Patent Document]

[Patent Document 1] JP6144404B2

DESCRIPTION OF THE DISCLOSURE

[Problem to be Solved by the Disclosure]

Meanwhile, the mechanical apparatus may perform a vibration-proof control for preventing vibration of an apparatus body. Particularly, as for a robot, the vibration-proof control of a robot body is generally performed. The technology of the failure diagnosis for the speed reducer has room for an improvement, when it is applied to a drive mechanism of the mechanical apparatus which carries out the vibration-proof control of the body.
The present disclosure is made in view of solving the above problems, and one purpose thereof is to provide a failure diagnosing device for a drive mechanism, capable of detecting a failure of the drive mechanism at an earlier stage in a mechanical apparatus which carries out a vibration-proof control of a body, and to provide a method of diagnosing the failure, and the mechanical apparatus provided with the failure diagnosing device.

[Summary of the Disclosure]

In order to achieve the purpose, according to one aspect of the present disclosure, a failure diagnosing device diagnoses a failure of a drive mechanism of a mechanical apparatus provided with a body including a motor, a speed reducer configured to slow down rotational power of the motor, and an operation part configured to operate by the rotational power slowed down by the speed reducer, and a vibration-proof controller configured to perform a vibration-proof control to prevent vibration of the body, the drive mechanism including the motor and the speed reducer. The failure diagnosing device sends a command for suspending the vibration-proof control to the vibration-proof controller of the mechanical apparatus, then identifies an acceleration-and-deceleration period during which operation of the mechanical apparatus of which the vibration-proof control is suspended accelerates and decelerates, and determines whether the drive mechanism indicates a sign of failure based on a change in a frequency spectrum of load current of the motor or a current value having a correlation with the load current (hereinafter, referred to as "the motor current") with respect to a change in a rotational speed of the motor, during the acceleration-and-deceleration period.
According to this configuration, during the acceleration-and-deceleration period of the mechanical apparatus, the current amplitude in a particular frequency range corresponding to a characteristic frequency of the failure of the drive mechanism increases by the resonance of the drive mechanism and indicates a peak value, in the change in the frequency spectra of the motor current with respect to the change in the rotational speed data of the motor, and this peak value has a correlation with a sign of the failure of the drive mechanism. Therefore, since it can be determined whether the drive mechanism indicates a sign of a failure based on the change in the frequency spectra of the motor current with respect to the change in the rotational speed data of the motor, the failure diagnosis can be performed during the work of the mechanical apparatus to which the drive mechanism is provided.
On the other hand, since this failure diagnosis utilizes the resonance of the drive mechanism, the peak value in the frequency spectra of the motor current becomes larger as the vibration of the body becomes larger, and therefore, the accuracy (sensibility) of determining whether the drive mechanism indicates a sign of failure improves. Therefore, like this configuration, the failure of the drive mechanism can be detected at an earlier stage upon the failure diagnosis by sending the command to the vibration-proof controller of the mechanical apparatus and suspending the vibration-proof control.

The determination of whether the drive mechanism indicates the sign of failure may be a determination of whether the speed reducer indicates a sign of failure.

According to this configuration, the failure of the speed reducer can be detected at an earlier stage.

The determination of whether the drive mechanism indicates the sign of failure may be a determination of whether the motor indicates a sign of failure.

According to this configuration, the failure of the motor can be detected at an earlier stage.

The failure diagnosing device may include a rotational speed acquiring module configured to acquire the rotational speed of the motor, an acceleration-and-deceleration period identifying module configured to identify the acceleration-and-deceleration period based on the rotational speed of the motor acquired by the rotational speed acquiring module, a motor current acquiring module configured to acquire the motor current, a time series rotational speed data generating module configured to sequentially sample the rotational speed of the motor acquired by the rotational speed acquiring module during the acceleration-and-deceleration period and generate a group of time series rotational speed data, a time series motor current data generating module configured to sequentially sample the motor current acquired by the motor current acquiring module during the acceleration-and-deceleration period and generate a group of time series motor current data, an FFT analyzing module configured to conduct a frequency analysis of the group of time series motor current data so as to correspond to the group of time series rotational speed data and generate frequency spectra of the group of motor current data corresponding to the group of time series rotational speed data, an amplitude peak value extracting module configured to extract a peak value of the amplitude of the motor current in a given frequency range corresponding to a frequency characteristic to the failure of the drive mechanism, from the frequency spectra of the group of motor current data, and a determining module configured to compare the extracted peak value of the amplitude of the motor current with a given amplitude threshold and determine whether the drive mechanism indicates the sign of failure based on the compared result.

According to this configuration, the failure diagnosing device capable of diagnosing the failure during the work of the mechanical apparatus to which the drive mechanism is provided, can be preferably embodied.

The failure diagnosing device may include an output device configured to output the determined result.

According to this configuration, the determined result can be informed.

The mechanical apparatus may be a robot.

According to this configuration, as for the robot, the vibration-proof control is generally performed, thus, the failure of the speed reducer of the robot can be detected at an earlier stage.

According to another aspect of the present disclosure, a mechanical apparatus includes the failure diagnosing devices of any one of those described above, a body including a motor, a speed reducer configured to slow down rotational power of the motor, and an operation part configured to operate by the rotational power slowed down by the speed reducer, and a vibration-proof controller configured to perform a vibration-proof control to prevent vibration of the body. The failure diagnosing device of the drive mechanism sends a command for suspending the vibration-proof control to the vibration-proof controller.

According to this configuration, diagnosing of the failure can be performed during the work of the mechanical apparatus.

In order to achieve the purpose, according to still another aspect of the present disclosure, a method of diagnosing a failure of a drive mechanism of a mechanical apparatus is provided. The mechanical apparatus is provided with a body including a motor, a speed reducer configured to slow down rotational power of the motor, and an operation part configured to operate by the rotational power slowed down by the speed reducer, and a vibration-proof controller configured to perform a vibration-proof control to prevent vibration of the body, the drive mechanism including the motor and the speed reducer. The method includes the steps of (a) causing the vibration-proof controller of the mechanical apparatus to suspend the vibration-proof control, (b) then identifying an acceleration-and-deceleration period during which operation of the mechanical apparatus of which the vibration-proof control is suspended accelerates and decelerates, and (c) determining whether the drive mechanism indicates a sign of failure based on a change in a frequency spectrum of load current of the motor or a current value having a correlation with the load current (hereinafter, referred to as "the motor current") with respect to a change in a rotational speed of the motor, during the acceleration-and-deceleration period.

According to this configuration, the failure of the drive mechanism can be detected at an earlier stage.

[Effect of the Disclosure]

The present disclosure can provide the failure diagnosing device for the drive mechanism, capable of detecting the failure of the drive mechanism at the earlier stage in the mechanical apparatus which carries out the vibration-proof control of the body, and provide the method of diagnosing the failure, and the mechanical apparatus provided with the failure diagnosing device.

BRIEF DESCRIPTION OF DRAWINGS

Fig. 1 is a functional block diagram illustrating a configuration of a failure diagnosing device for a drive mechanism according to one embodiment of the present disclosure.

Fig. 2 is a view schematically illustrating a change in frequency spectra of motor current with respect to a change in a rotational speed of a motor.

Fig. 3A is a contour view illustrating a change in the frequency spectra of the motor current with respect to the change in the rotational speed of the motor of a speed reducer which is in a state of an early stage of the failure during an endurance test.

Fig. 3B is a contour view illustrating a change in the frequency spectra of the motor current with respect to the change in the rotational speed of the motor of the speed reducer which is in a state of a terminal stage of the failure during the endurance test.

Fig. 4 is a view illustrating one example of an inertia model of a robot in a vibration-proof control by a vibration-proof controller and a motion controller in Fig. 1.

Fig. 5 is a view illustrating a control system of the robot corresponding to the inertia model in Fig. 4.

Figs. 6(a) and 6(b) are views illustrating a resonance frequency of a 4-inertia model and a 2-inertia model, respectively.

Figs. 7(a) and 7(b) are views illustrating a change in a torque compensation amount when the motor is stopped in a case of a pole assignment, and in a case of assigning zero point at the origin, respectively.

Fig. 8 is a view illustrating the 2-inertia model.

Fig. 9 is a flowchart illustrating operation of the failure diagnosing device in Fig. 1.

Fig. 10 is a graph illustrating a difference of a value of a frequency component (amplitude of the motor current) in the frequency spectra of the motor current in a state where the vibration-proof control of the robot body is turned off, from the value in a state where the vibration-proof control is turned on.

MODE FOR CARRYING OUT THE DISCLOSURE

(Knowledge Used as Basis of Present Disclosure)

The above technology of the failure diagnosis for the speed reducer is a technology developed by the present applicant. According to this technology, a failure of the speed reducer can be detected at an early stage. In the meantime, there is a request from the industry for detecting the failure of the speed reducer for a robot at an early stage. The present inventors diligently examined it in order to answer the request. As a result, they acquired the following knowledge.

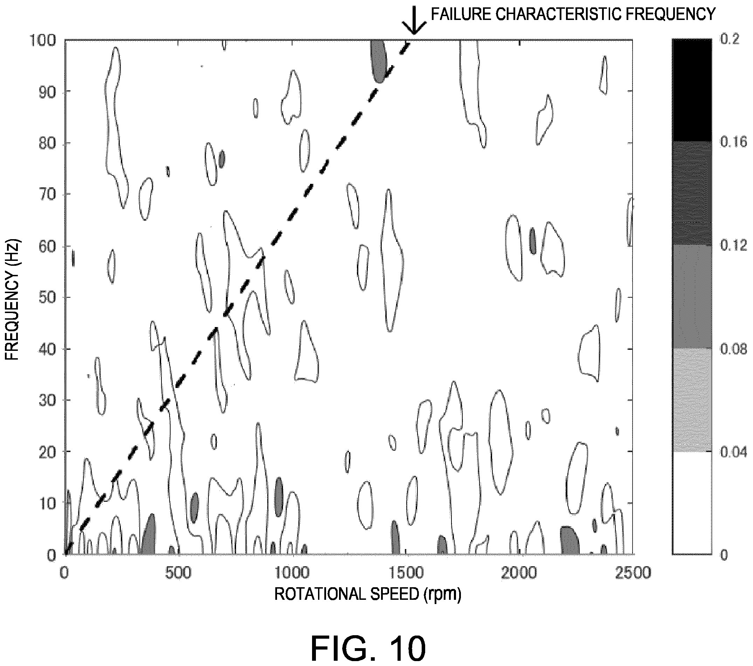

The present inventors focused on that this failure diagnosis uses an increase in resonance of the speed reducer due to a failure, and a robot generally performs a vibration-proof control of a robot body. That is, the present inventors considered that, if the failure diagnosis uses the increase in the resonance of the speed reducer due to the failure, since a peak value in the frequency spectra of the motor current becomes larger as the vibration of the body increases, it became easier to detect the failure of the speed reducer. Thus, they experimented to find out whether a value of a frequency component (amplitude of the motor current) in the frequency spectra of the motor current differs between a state where a vibration-proof control of the robot body is turned on and a state where the vibration-proof control is turned off. As the result, it was confirmed that the value of the frequency component (amplitude of the motor current) which is characteristic to the failure of the speed reducer in the frequency spectra of the motor current became larger in the state where the vibration-proof control of the robot body is turned off than the state where the vibration-proof control is turned on (see Fig. 10 etc.).

Moreover, in this experiment, it was confirmed that the main factor of vibrating the motor current is the vibration of the robot body, the vibration of the frequency characteristic to the failure of the speed reducer appears in the vibration of the robot body, and as a result, it appears in the motor current. Moreover, based on the above, it was reasoned that, when the motor is failed, the vibration of the frequency characteristic to the failure of the motor appears in the motor current by a principle (mechanism) similar to the failure of the speed reducer.

It is apparent that this experimental results can also be applied to the mechanical apparatus which carries out the vibration-proof control of the body other than the robot.

Therefore, the present inventors reached to performing a failure diagnosis of a drive mechanism including a motor and a speed reducer which slows down a rotational power of the motor, in a mechanical apparatus which carries out a vibration-proof control of a body, while suspending the vibration-proof control.

Note that, in the mechanical apparatus, since there is operation accompanied by acceleration and deceleration without interfering a work, even if the vibration-proof control is suspended, for example when starting or ending the work, it is possible to perform the failure diagnosis of the drive mechanism during the work, while the vibration-proof control is suspended.

According to the present disclosure, the failure of the drive mechanism can be detected at an early stage, as compared with a case where the vibration-proof control is not suspended. As a result, in the mechanical apparatus which carries out the vibration-proof control of the body, the failure of the drive mechanism can be detected at an earlier stage.

Hereinafter, one embodiment that implements the present disclosure is described with reference to the accompanying drawings. Note that, below, the same reference characters are assigned to the same or corresponding elements throughout the drawings to omit redundant description.

(Embodiment)

[Configuration]

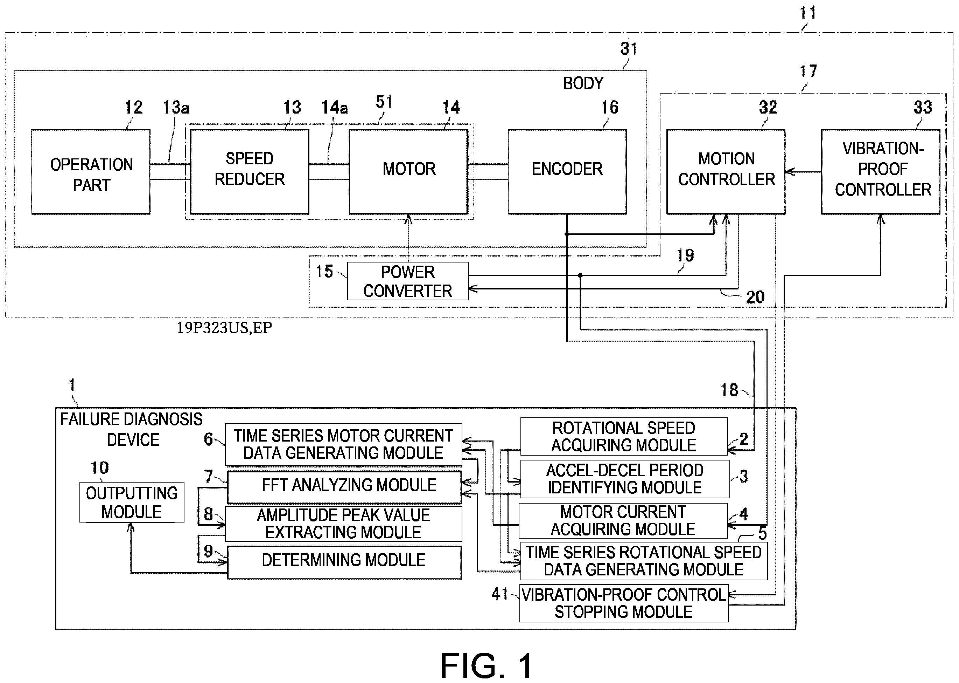

Fig. 1 is a functional block diagram illustrating a configuration of a failure diagnosing device for a drive mechanism according to one embodiment of the present disclosure.

Referring to Fig. 1, in a mechanical apparatus 11 provided with a body 31 having a motor 14, a speed reducer 13 which slows down rotational power of the motor 14, and an operation part 12 which operates by the rotational power slowed down by the speed reducer 13, and a vibration-proof controller 33 which performs a vibration-proof control for preventing vibration of the body 31, a failure diagnosing device 1 for the drive mechanism (hereinafter, simply referred to as "the failure diagnosing device 1") diagnoses a failure of a drive mechanism 51 including the motor 14 and the speed reducer 13. The failure diagnosing device 1 is adapted to send a command for causing the vibration-proof controller 33 of the mechanical apparatus 11 to suspend the vibration-proof control, then identify an acceleration-and-deceleration period during which operation of the mechanical apparatus 11 of which the vibration-proof control is suspended accelerates and decelerates (hereinafter, simply referred to as "the acceleration-and-deceleration period"), and determine whether the drive mechanism 51 indicates a sign of a failure during the acceleration-and-deceleration period based on a change in the frequency spectra of the motor current of the motor 14 with respect to a change in the rotational speed of the motor 14.

Hereinafter, this is described concretely.

<Mechanical Apparatus 11>

First, the drive mechanism 51 including the motor 14 and the speed reducer 13, and the mechanical apparatus 11 provided with the drive mechanism 51, which are diagnosis targets of the failure diagnosing device 1, are described.

The mechanical apparatus 11 includes the body 31 and a controller 17. The controller 17 includes a power converter 15 which supplies the controlled electric power (here, electric current) to the motor 14 of the body 31, a motion controller 32 which controls operation of the body 31 by using the power converter 15, and the vibration-proof controller 33 which performs a vibration preventive control for preventing the vibration of the body 31.

The body 31 includes the operation part 12, the motor 14 which drives the operation part 12, the speed reducer 13 which slows down the rotational power of the motor 14 and transmits it to the operation part 12, and an encoder 16 which detects a rotational position of the motor 14. The drive mechanism 51 is comprised of the motor 14 as a driving source, and a power transmission path from the motor 14 to the operation part 12. The speed reducer 13 constitutes a part of the power transmission path.

The mechanical apparatus 11 may be any apparatus, as long as it includes the operation part 12. The mechanical apparatus 11 is typically a robot. In the robot, the operation part of the robot body constitutes the operation part 12 of the body 31. For example, in an articulated robot, a pedestal (base) fixed to a fixing object constitutes a stationary part, and one or more joints and arm members (links) which are coupled to the pedestal, and an end effector constitute the operation part 12. The mechanical apparatus 11 includes a construction machinery and a machine tool, other than those described above.

The speed reducer 13 may be any speed reducer, as long as it slows down the rotational power of the motor 14 and transmits it to the operation part 12. For example, the speed reducer 13 slows down the rotational power of an input shaft by a deceleration mechanism (not illustrated) and outputs the slowed-down rotational power to an output shaft 13a. Although a rotation shaft 14a of the motor 14 is illustrated as an input shaft in Fig. 1, it may be an output shaft of another operation part, for example. Moreover, although a reduction gear mechanism is typically illustrated as the deceleration mechanism, it may be other deceleration mechanisms.

The motor 14 is a servomotor, or may be a brushless motor or a direct-current motor. However, it may be other motors, such as an induction motor. If the servomotor is used, a position control of the operation part 12 is performed by also using the encoder 16. The installed location of the motor 14 may be at the stationary part of the mechanical apparatus 11, or the operation part 12. In the case of the robot, since the motor 14 is provided in each joint to drive the arm member at a tip-end side of each joint except for a first joint, the motor 14 is provided to the operation part 12 at the joints other than the first joint. At the first joint, it is provided to the stationary part.

The encoder 16 is provided to the rotation shaft 14a of the motor 14. The encoder 16 may by any encoder, as long as it detects a rotation angle (rotational position) of the motor 14. Note that, when the motor 14 is comprised of the induction motor etc. and the position control of the operation part 12 is not performed, a rotational speed detector is used, for example, instead of the encoder 16.

The power converter 15 supplies to the motor 14 electric power of which the voltage or current is controlled (current is controlled in Fig. 1) to drive the motor 14. Since the power converter 15 is well-known, concrete description thereof is omitted. In Fig. 1, the power converter 15 is provided with a current sensor (not illustrated) which detects current supplied to the motor 14 (load current of the motor 14) and outputs the detected current 19 to the motion controller 32. The current sensor may be provided outside the power converter 15.

The motion controller 32 generates a current command value 20 based on the rotation angle of the motor 14 inputted from the encoder 16 and the motor current 19 inputted from the current sensor of the power converter 15, and outputs it to the power converter 15. The power converter 15 outputs electric power of the current according to the current command value 20 to the motor 14. In this way, the motion controller 32 carries out a feedback control of the rotation angle and the torque of the motor 14.

The vibration-proof controller 33 collaboratively perform the vibration-proof control with the motion controller 32. This vibration-proof control is described later in detail.

The motion controller 32 and the vibration-proof controller 33 are comprised of an arithmetic unit. The arithmetic unit includes a personal computer and a microcontroller, for example. The motion controller 32 and the vibration-proof controller 33 (arithmetic unit) have a processor and a memory, and perform a given motion control and a given vibration-proof control by the processor reading and executing a given control program stored in the memory. The motion controller 32 and the vibration-proof controller 33 are functional parts which are implemented by executing the given control program, and the arithmetic unit actually operates as the motion controller 32 and the vibration-proof controller 33.

Note that the vibration-proof controller 33 may be omitted and the motion controller 32 may be provided with the function of the vibration-proof controller 33.

<Failure Diagnosing Device 1>

Next, the failure diagnosing device 1 is described.

The failure diagnosing device 1 is comprised of an arithmetic unit. The arithmetic unit includes, for example, a personal computer and a microcontroller, which operate according to a program (software), and hardware such as a logic circuit and an electronic circuit. Here, the failure diagnosing device 1 is comprised of the arithmetic unit which operates according to the program. The failure diagnosing device 1 (arithmetic unit) has the processor and the memory, and performs the given failure diagnosis by the processor reading and executing a given failure diagnosis program stored in the memory. The failure diagnosing device 1 includes a rotational speed acquiring module 2, an acceleration-and-deceleration period identifying module 3, a motor current acquiring module 4, a time series rotational speed data generating module 5, a time series motor current data generating module 6, an FFT analyzing module 7, an amplitude peak value extracting module 8, a determining module 9, an outputting module 10, and a vibration-proof control stopping module 41.

Functional parts 2-9 and 41 are functional parts implemented by executing the given failure diagnosis program, and the arithmetic unit actually operates as the functional parts 2-9 and 41.

The vibration-proof control stopping module 41 controls the entire operation of the failure diagnosing device 1. When starting the failure diagnosis, the vibration-proof control stopping module 41 outputs a vibration-proof control stop command to the vibration-proof controller 33 of the mechanical apparatus 11, and when an operation start signal is received from the motion controller 32 of the mechanical apparatus 11, it starts the failure diagnosis by each of the functional parts 2-9.

The rotational speed acquiring module 2 acquires the rotational speed of the motor 14 based on the rotation angle of the motor 14 inputted from the encoder 16 (then, it is saved temporarily). Note that, if the rotational speed detector is provided instead of the encoder 16, it acquires the rotational speed of the motor 14 based on the rotational speed inputted from the rotational speed detector.

The acceleration-and-deceleration period identifying module 3 identifies an acceleration-and-deceleration period based on the rotational speed of the motor acquired by the rotational speed acquiring module 2.

Here, the motor current acquiring module 4 acquires the current 19 inputted from the current sensor (not illustrated) of the power converter 15 as the "motor current" (then, it is saved temporarily). Note that the current command value 20 inputted from the motion controller 32 may be acquired as the "motor current." Note that the current command value is a command signal according to a deviation of the present value from the load current of the motor, from which a result not inferior to the load current of the motor can be obtained.

The time series rotational speed data generating module 5 sequentially samples the rotational speed of the motor acquired by the rotational speed acquiring module 2 during the acceleration-and-deceleration period, and generates a group of time series rotational speed data.

The time series motor current data generating module 6 sequentially samples the motor current acquired by the motor current acquiring module 4 during the acceleration-and-deceleration period, and generates a group of time series motor current data.

Here, segmenting (extracting) and sampling of the rotational speed data and the motor current data are described. The rotational speed acquiring module 2 and the motor current acquiring module 4 acquire the motor rotational speed and the motor current as the time series data, respectively. As for the time series data, although it is necessary to perform the segmenting of a part of the acceleration-and-deceleration period and the sampling, either one may be performed first. Moreover, for the sampling, the sampling frequency according to the rotational speed of the motor is determined so that a sampling number in one revolution of the motor is defined, and the defined number of samplings are performed even if the rotational speed of the motor changes.

The FFT analyzing module 7 conducts a frequency analysis while corresponding the group of time series motor current data to the group of time series rotational speed data, and generates the frequency spectra of the group of the motor current data corresponding to the group of time series rotational speed data. This frequency analysis (hereinafter, may be referred to as a "three-dimensional frequency analysis") is conducted by using an FFT (fast Fourier transform), for example.

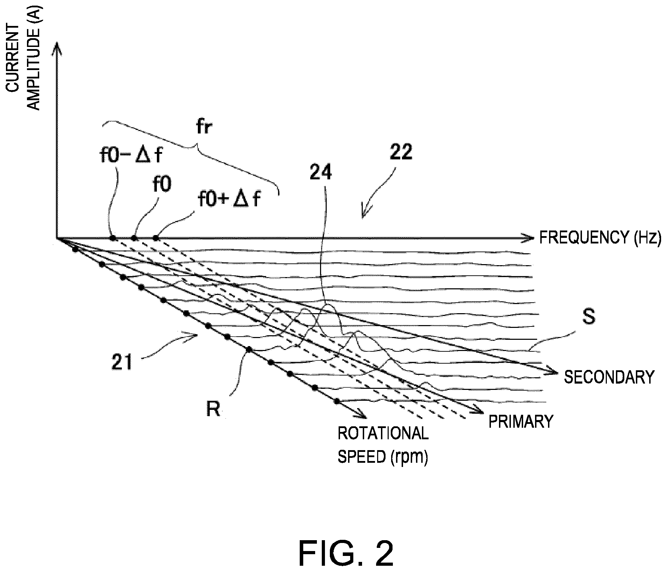

Fig. 2 is a view schematically (conceptually) illustrating a change in the frequency spectra of the motor current with respect to a change in the rotational speed of the motor, where the frequency analysis is indicated three-dimensionally. In Fig. 2, the X-axis indicates a rotational speed (rpm), the Y-axis indicates a frequency (Hz), and the Z-axis indicates an amplitude (A) of the motor current. On the X-axis, a group of time series rotational speed data 21 is located. A reference character R indicates each rotational speed data. Frequency spectra 22 of the group of the motor current data exist corresponding to the group of time series rotational speed data 21. A reference character S indicates a frequency spectrum of each motor current data. In Fig. 2, only a primary rotational speed (basic rotational speed) and a secondary rotational speed are illustrated for simplification. A reference character f indicates a frequency, and f0 indicates a frequency characteristic to a failure of an element (for example, the speed reducer 13) which constitutes the drive mechanism 51 (a resonance frequency, and hereinafter, it may be referred to as a "characteristic frequency"). Below, for simplification, the failure of the element which constitutes the drive mechanism 51 may be referred to as "the failure of the drive mechanism 51," and the characteristic frequency of the failure of the element which constitutes the drive mechanism 51 may be referred to as "the characteristic frequency of the failure of the drive mechanism 51." A range where the frequency is (f0-Δf)≤f≤(f0+Δf) indicates a given frequency range fr. In this given frequency range fr, the amplitude of the current in the frequency spectrum S of the motor current data increases by the resonance of the speed reducer 13, and presents a peak value 24.

Note that, actually, a large number of rotational speed data R are located on the X-axis, and the frequency spectra S of a large number of motor current data corresponding to the large number of rotational speed data R exist. Moreover, during the failure diagnosis, since data corresponding to the acceleration-and-deceleration period are segmented from the time series rotational speed data, the rotational speed data 21 may be located only in a partial range on the X-axis, and only the frequency spectra 22 of the motor current data corresponding to the rotational speed data 21 may exist.

Referring to Figs. 1 and 2, the amplitude peak value extracting module 8 extracts a peak value of the amplitude of the motor current in the given frequency range fr corresponding to the characteristic frequency f0 of the failure of the drive mechanism 51, among the frequency spectra S of the group of motor current data. The characteristic frequency f0 of the failure of the drive mechanism 51 is determined in advance by an experiment, a simulation, a calculation, etc., for one or more given elements which constitute the drive mechanism 51, and is stored in the memory (not illustrated) of the failure diagnosing device 1.

The determining module 9 compares the extracted peak value 24 of the amplitude of the motor current with a given amplitude threshold, and, based on this result, it determines whether one or more given elements (in other words, the drive mechanism 51) which constitute the drive mechanism 51 indicates a sign of failure. In detail, if the peak value 24 of the amplitude of the motor current is above the given amplitude threshold, it determines that the drive mechanism 51 indicates a sign of the failure, and if the peak value 24 of the amplitude of the motor current is below the given amplitude threshold, it determines that the drive mechanism 51 does not indicate a sign of the failure. This amplitude threshold is determined by an experiment, a simulation, etc. The amplitude threshold is determined corresponding to an allowable threshold indicative of an allowable limit of a physical quantity (parameter) relevant to a degradation (a sign of failure) of the drive mechanism 51. In this embodiment, for example, in the case of the speed reducer 13, it is determined corresponding to the allowable threshold of an iron powder concentration of grease of the speed reducer.

The outputting module 10 outputs the determination result by the determining module 9. For example, the outputting module 10 is comprised of a display or an alarm which displays the determination result, a transmitter which transmits the determination result to an external device, and a printer which prints the determination result.

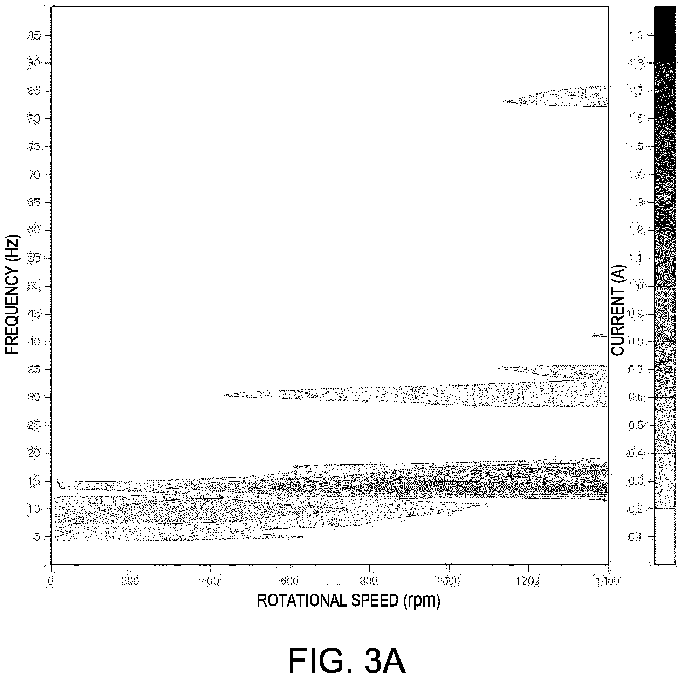

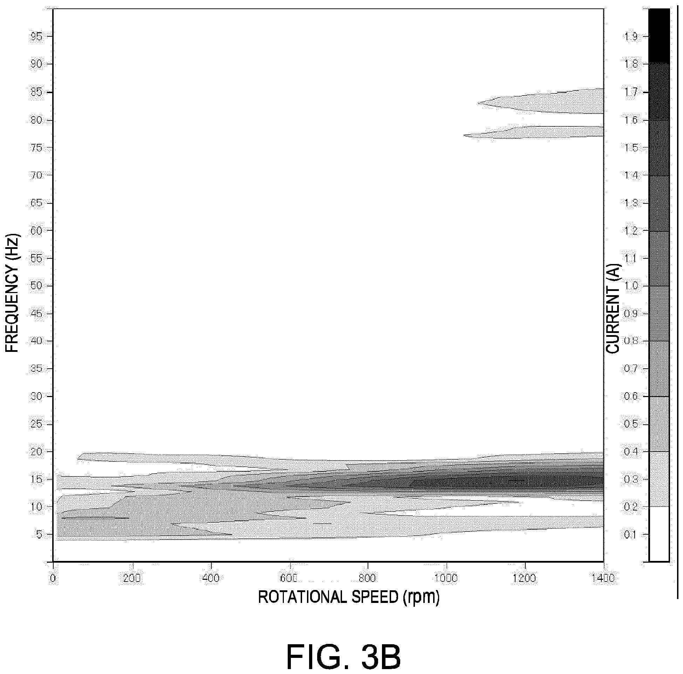

Fig. 3A is a contour view illustrating a change in the frequency spectra of the motor current with respect to a change in the rotational speed of the motor of the speed reducer which is in a state of an early stage of a failure during an endurance test. Fig. 3B is a contour view illustrating a change in the frequency spectra of the motor current with respect to a change in the rotational speed of the motor of the speed reducer which is in a state of a terminal stage of the failure during the endurance test.

In Figs. 3A and 3B, the X-axis indicates a rotational speed (rpm) of the motor, the Y-axis indicates a frequency, and a gradation of an image indicates an amplitude (A) of the motor current. The amplitude of the motor current becomes larger as the image is deeper (more black), and it becomes smaller as the image is lighter (more white).

Referring to Figs. 3A and 3B, it can be seen that an area where the amplitude of the motor current is large appears near 14Hz (i.e., the amplitude of the motor current indicates a peak value. Further, it can be seen that the amplitude of the motor current becomes larger (the image becomes deeper) as the endurance test progresses.

Therefore, it is demonstrated from the result of the endurance test that, for the change in the frequency spectra of the motor current with respect to the change in the rotational speed of the motor, the current amplitude of the particular frequency range corresponding to the characteristic frequency of failure of the speed reducer increases, and a clear peak value is appeared.

Note that, please refer to JP6144404B2 for the detail of this endurance test.

<Vibration-proof Control>

Next, the vibration-proof control is described in detail. The vibration-proof control is accomplished, for example, by a collaborative operation of the vibration-proof controller 33 and the motion controller 32. The vibration-proof controller 33 may be any controller, as long as it can prevent vibration of the body of the mechanical apparatus 11.

Below, when the mechanical apparatus 11 is an articulated robot, the vibration-proof control for preventing vibration of the robot body, and configurations of the vibration-proof controller 33 and the motion controller 32 for accomplishing the vibration-proof control are described. Note that the vibration-proof control described below is known, and, please refer to JP5411687B2 for the detail.

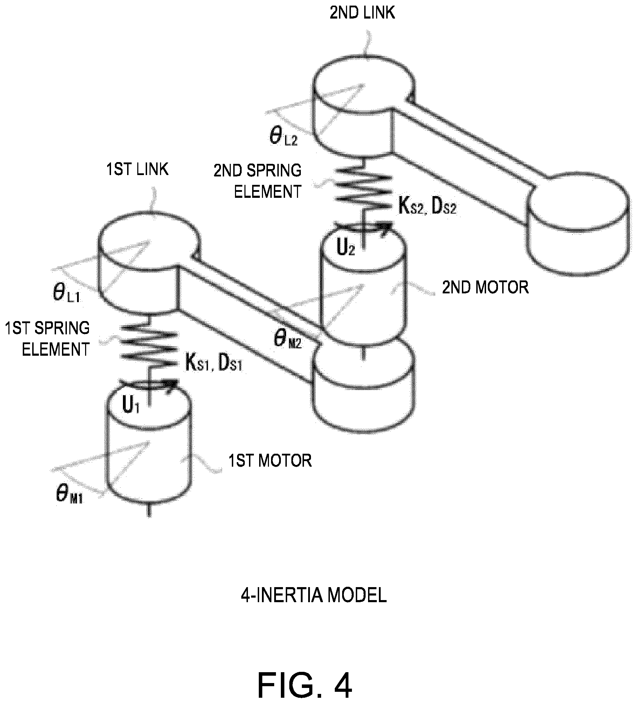

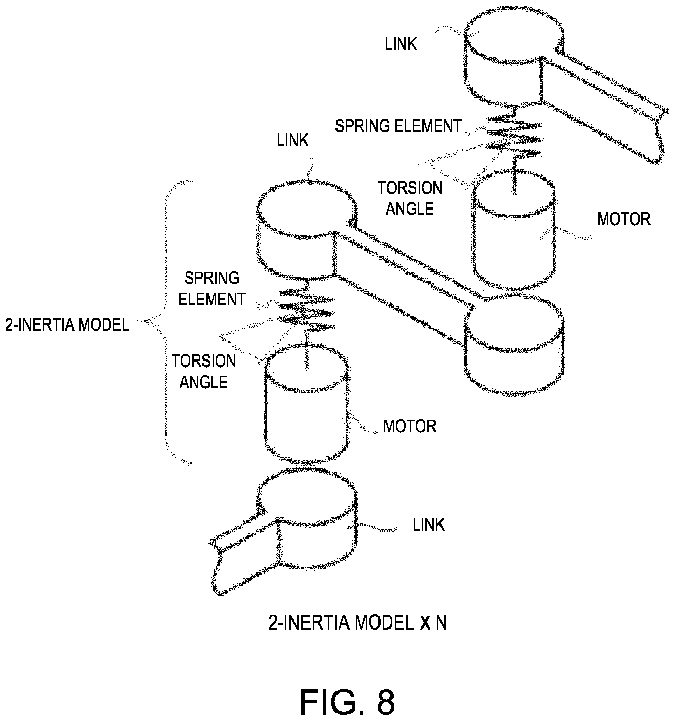

Fig. 4 illustrates a model of the robot according to the vibration-proof control. The model illustrated in Fig. 4 is a 4-inertia model, and is a model in consideration of the rigidity and the attenuation of a spring element between a motor and an arm. Moreover, unlike a 2-inertia model in Fig. 8 (described later), it is a model in consideration of the motor being attached to a link other than a link driven by the model (i.e., a model in consideration of interferences between a plurality of links). Note that the term "spring element" in the vibration-proof control as used herein refers what couples the motor to the link in a broad sense, and it also includes a torque transmission mechanism, such as a speed reducer, which transmits torque to the link from a motor shaft or the motor.

The 4-inertia model of Fig. 4 is comprised of a first motor and a second motor, a first link and a second link which are driven by the motors, and a first spring element and a second spring element between the motor and the link.

In Fig. 4, angles $\theta_{M1}$ and $\theta_{M2}$ are turning angles (angle position) of the first and second motors, respectively. The angles $\theta_{L1}$ and $\theta_{L2}$ are angles of the first and second links, respectively. Torsion angles of the first and second spring elements are given by $\theta_{M1}-\theta_{L1}$ and $\theta_{M2}-\theta_{L2}$, respectively. Moreover, $K_{S2}$ and $K_{S3}$ are rigidities of the first and second spring elements, and $D_{S2}$ and $D_{S3}$ are attenuations of the first and second spring elements, respectively. Moreover, $u_1$ and $u_2$ are output torques of the first and second motors, respectively.

If nonlinear elements, such as a centrifugal force and a Coriolis force, are ignored, an equation of motion of the 4-inertia model illustrated in Fig. 4 can be expressed as Formulas 1 to 4.

$$J_{L11}\ddot{\theta}_{L1} + J_{L12}\ddot{\theta}_{L2} + J_{M2}\left(\ddot{\theta}_{M2} + \ddot{\theta}_{L1}\right) = K_{S1}\left(\theta_{M1} - \theta_{L1}\right) + D_{S1}\left(\dot{\theta}_{M1} - \dot{\theta}_{L1}\right)$$

$$\ldots(1)$$

$$J_{L21}\ddot{\theta}_{L1} + J_{L22}\ddot{\theta}_{L2} = K_{S2}\left(\theta_{M2} - \theta_{L2}\right) + D_{S2}\left(\dot{\theta}_{M2} - \dot{\theta}_{L2}\right) \qquad \ldots(2)$$

$$J_{M1}\ddot{\theta}_{M1} + K_{S1}\left(\theta_{M1} - \theta_{L1}\right) + D_{S1}\left(\dot{\theta}_{M1} - \dot{\theta}_{L1}\right) = u_1 \qquad \ldots(3)$$

$$J_{M2}\left(\ddot{\theta}_{M2} + \ddot{\theta}_{L1}\right) + K_{S2}\left(\theta_{M2} - \theta_{L2}\right) + D_{S2}\left(\dot{\theta}_{M2} - \dot{\theta}_{L2}\right) = u_2 \qquad \ldots(4)$$

In Formulas 1 to 4, $J_{L11}$, $J_{L12}$, $J_{L21}$, and $J_{L22}$ are coefficients which can be found from robot parameters, such as the masses of the links, the centers of gravity, and the lengths, and the angles $\theta_{L1}$ and $\theta_{L2}$ of the links. Moreover, $J_{M1}$ and $J_{M2}$ are inertias of the first and second motors, respectively. Further,

$$\dot{\theta}_{M1} - \dot{\theta}_{L1}$$

and

$$\dot{\theta}_{M2} - \dot{\theta}_{L2}$$

are torsion angular velocities of the first and second spring elements, respectively.

The next equation of state of Formula 5 can be obtained from these four equations of motion.

$$\dot{x} = Ax + Bu \qquad \ldots(5)$$

$$x = \begin{bmatrix} \theta_{M1} & \theta_{M2} & \theta_{M1} - \theta_{L1} & \theta_{M2} - \theta_{L2} & \dot{\theta}_{M1} & \dot{\theta}_{M2} & \dot{\theta}_{M1} - \dot{\theta}_{L1} & \dot{\theta}_{M2} - \dot{\theta}_{L2} \end{bmatrix}^T$$

$$u = \begin{bmatrix} u_1 & u_2 \end{bmatrix}^T$$

$$A = \begin{bmatrix} 0 & 0 & 0 & 0 & 1 & 0 & 0 & 0 \\ 0 & 0 & 0 & 0 & 0 & 1 & 0 & 0 \\ 0 & 0 & 0 & 0 & 0 & 0 & 1 & 0 \\ 0 & 0 & 0 & 0 & 0 & 0 & 0 & 1 \\ 0 & 0 & -K_{S1}\dfrac{1}{J_{M1}} & 0 & 0 & 0 & -D_{S1}\dfrac{1}{J_{M1}} & 0 \\ 0 & 0 & 0 & -K_{S2}\dfrac{1}{J_{M2}} & 0 & 0 & 0 & -D_{S2}\dfrac{1}{J_{M2}} \\ 0 & 0 & -K_{S1}\dfrac{J_{M1}J_{L22}+S}{J_{M1}S} & -K_{S2}\dfrac{J_{L22}-J_{L12}}{S} & 0 & 0 & -D_{S1}\dfrac{J_{M1}J_{L22}+S}{J_{M1}S} & -D_{S2}\dfrac{J_{L22}-J_{L12}}{S} \\ 0 & 0 & K_{S1}\dfrac{J_{L21}}{S} & -K_{S2}\dfrac{J_{M1}(J_{L1}+J_{M2}-J_{L21})+S}{J_{M2}S} & 0 & 0 & D_{S1}\dfrac{J_{L21}}{S} & -D_{S2}\dfrac{J_{M1}(J_{L1}+J_{M2}-J_{L21})-S}{J_{M2}S} \end{bmatrix}$$

$$B = \begin{bmatrix} 0 & 0 \\ 0 & 0 \\ 0 & 0 \\ 0 & 0 \\ \dfrac{1}{J_{M1}} & 0 \\ 0 & \dfrac{1}{J_{M2}} \\ \dfrac{1}{J_{M1}} & \dfrac{J_{L11}}{S} \\ 0 & \dfrac{S-J_{M1}J_{L21}}{J_{M2}S} \end{bmatrix}$$

$$S = \left(J_{L11}+J_{M2}\right)J_{L22} - J_{L12}J_{L21}$$

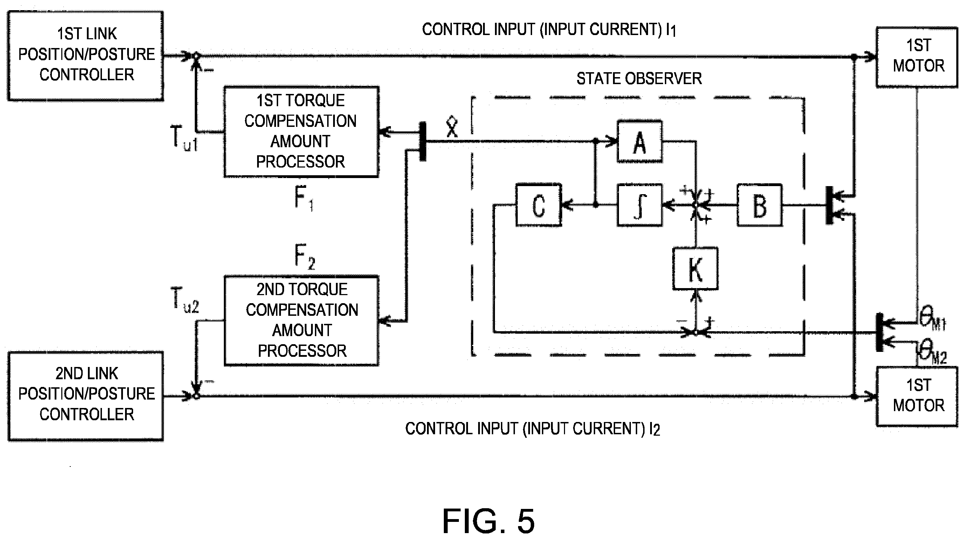

Parts of block diagrams of a control system of the first and second motors including a state observer to which the 4-inertia model described above is applied (i.e., a control system of the vibration-proof controller 33 and the motion controller 32) are illustrated in Fig. 5.

The state observer illustrated in Fig. 5 is an observer based on the equation of state of Formula 5 and an output equation of Formula 6 (i.e., an observer in consideration of an interference between the first link and the second link). This state observer is a component of the vibration-proof controller 33. Matrixes A, B, and C are matrix determined by the 4-inertia model. As will be described later in detail, a matrix K is a design parameter of the state observer and is a feedback gain matrix. "∫" is an integrator.

$$y = Cx \qquad \ldots(6)$$

Based on control inputs (input current corresponding to torques $u_1$ and $u_2$) $I_1$ and $I_2$ to the first and second motors, respectively, and the turning angles $\theta_{M1}$ and $\theta_{M2}$ of the first and second motors, respectively, the state observer estimates as a state x, torsion angle $\theta_{M1}$-$\theta_{L1}$ and the torsion angular velocities of the first spring element

$$\dot{\theta}_{M1} - \dot{\theta}_{L1}$$

and the torsion angle $\theta_{M2}$-$\theta_{L2}$ and the torsion angular velocities of the second spring element

$$\dot{\theta}_{M2} - \dot{\theta}_{L2}.$$

Strictly speaking, the state observer estimates the torsion angle $\theta_{M1}$-$\theta_{L1}$ and the torsion angular velocities of the first spring element

$$\dot{\theta}_{M1} - \dot{\theta}_{L1}$$

based on the input current $I_1$ of the first motor and the input current $I_2$ of the second motor, and the turning angle $\theta_{M1}$ of the first motor and the turning angle $\theta_{M2}$ of the second motor. Moreover, it estimates the torsion angle $\theta_{M2}$-$\theta_{L2}$ and the torsion angular velocities of the second spring element

$$\dot{\theta}_{M2} - \dot{\theta}_{L2}$$

based on the input current $I_1$ of the first motor and the input current $I_2$ of the second motor, and the turning angle $\theta_{M1}$ of the first motor and the turning angle $\theta_{M2}$ of the second motor.

Therefore, this state observer can estimate the torsion angle $\theta_{M1}$-$\theta_{L1}$ and the torsion angular velocities of the first spring element

$$\dot{\theta}_{M1} - \dot{\theta}_{L1}$$

with higher precision, as compared with the case where they are estimated only based on the input current $I_1$ of the first motor and the turning angle $\theta_{M1}$ of the first motor. Moreover, the torsion angle $\theta_{M2}$-$\theta_{L2}$ and the torsion angular velocities of the second spring element

EP 3 881 989 A1

$$\dot{\theta}_{M2} - \dot{\theta}_{L2}$$

can be estimated with higher precision, as compared with the case where they are estimated only based on the input current $I_2$ of the second motor and the turning angle $\theta_{M2}$ of the second motor.

Note that, instead of the turning angles $\theta_{M1}$, $\theta_{M2}$ of the first and second motors, a rotation angular velocity

$$\dot{\theta}_{M1}, \dot{\theta}_{M2}$$

may be used. That is, the state observer estimates the state x based on an actually-observable one of the turning angle and the rotation angular velocity (for example, one detectable by a sensor (encoder)).

First and second torque compensation amount processors illustrated in Fig. 5 calculate torque compensation amounts $T_{u1}$ and $T_{u2}$ by using Formulas 7 and 8 based on the state x estimated by the state observer, respectively.

$$T_{u1} = F_1 x \qquad \ldots (7)$$

$$T_{u2} = F_2 x \qquad \ldots (8)$$

In Formulas 7 and 8, $F_1$ and $F_2$ are gain matrixes for calculating the torque compensation amounts $T_{u1}$ and $T_{u2}$. In detail, the gain matrixes $F_1$ and $F_2$ are matrixes for calculating the torque compensation amounts $T_{u1}$ and $T_{u2}$ to be added to the input currents $I_1$ and $I_2$ of the first and second motors so that the first and second motors output torques which can cancel the torsions of the first and second spring elements from the state x estimated by the state observer (the torsion angles and the torsion angular velocities), respectively.

The torque compensation amount $T_{u1}$ calculated by the first torque compensation amount processor is added to the input current $I_1$ to the first motor, which is outputted from a first link position/attitude controller. The first link position/attitude controller is a component of the motion controller 32, which controls the first motor, in order to control the position and the posture of the first link.

Moreover, the torque compensation amount $T_{u2}$ calculated by the second torque compensation amount processor is added to the input current $I_2$ to the second motor outputted from the second link position/attitude controller. The second link position/attitude controller is a component of the motion controller 32, which controls the second motor, in order to control the position and the posture of the second link.

By such a state observer and first and second torque compensation amount processors, the torsions of the first and second spring elements are eliminated in consideration of the interference between the first link and the second link. As a result, the vibration of the first and second links is fully suppressed.

Moreover, as another effect, it is possible to calculate a plurality of resonance frequencies, since the interference between the first link and the second link is taken into consideration (that is, since it is the 4-inertia model).

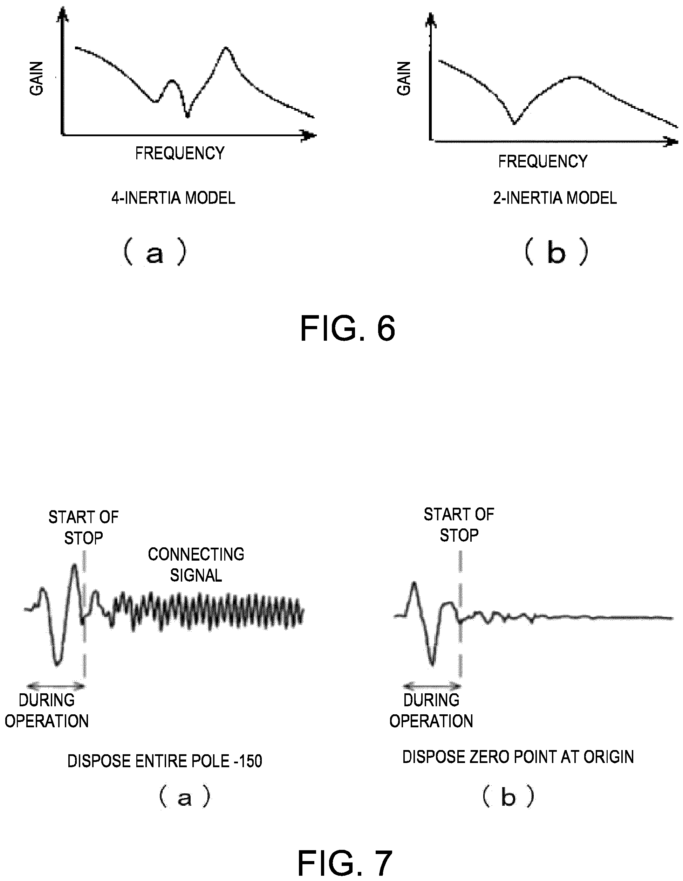

It is described concretely. Fig. 6(a) is a view illustrating a gain characteristic (embodiment) from the input current to the first motor to an estimated value of the rotation angular velocity of the motor in the 4-inertia model illustrated in Fig. 4. On the other hand, Fig. 6(b) is a view illustrating a gain characteristic (comparative example) from the input current to the motor to the estimated value of the rotation angular velocity of the motor in the 2-inertia model.

As illustrated in Fig. 6(a), in the case of the 4-inertia model (i.e., when the interference between the first link and the second link is taken into consideration), it has two resonance frequencies in behaviors of the first spring element and the second spring element. On the other hand, as illustrated in Fig. 6(b), in the case of the 2-inertia model, the spring element between the motor and the link has one resonance frequency in the behavior.

Therefore, although there are a plurality of motors and links, the 2-inertia model cannot take a plurality of actually-existing resonance frequencies into consideration, and it can only take one resonance frequency into consideration for each spring element. Therefore, a spillover problem due to the resonance frequency which is not taken into consideration arises. On the other hand, if the interference between the links is taken into consideration, N resonance frequencies can be taken into consideration when the 2N inertia model in which N motors and N links exist in order for

11

the 4-inertia model to take the two resonance frequencies into consideration for each spring element.

Moreover, the state observer is configured to set the gain of the torque compensation amount processor largely (that is, to further fully suppress the vibration of the first link and the second link).

This is described concretely.

Supposing that the estimated value of the state x of the state observer is

$$\hat{x} ,$$

the configuration of the state observer illustrated in Fig. 5 can be expressed as Formula 9.

$$\dot{\hat{x}} = A\hat{x} + Bu + K(y - C\hat{x}) \qquad ...(9)$$

If an error between the state estimated by the state observer

$$\hat{x}$$

and the actual state x is "e"

$$(e = x - \hat{x}) ,$$

Formula 10 can be obtained from Formula 9.

$$\dot{e} = (A - KC)e \qquad ...(10)$$

Convergence of the error e depends on a feedback gain matrix K, and the feedback gain matrix K is generally designed so that the real part of the pole of (A-KC) of Formula 10 becomes negative by the pole assignment. A convergence degree of the error e is determined by a value of the real part of the pole.

However, if the feedback gain matrix K is designed so that the real part of the pole of (A-KC) of Formula 10 becomes negative by the pole assignment, continuous oscillation occurs in the first link and the second link when the motor is stopped.

The occurrence of the continuous oscillation is caused by the characteristic of the motor. Normally, since the motor has nonlinear statical friction, a dead band exists near zero input current, and an offset of the input current occurs when the motor is stopped. Moreover, since the gravity acts on the link, the motor needs to output torque for maintaining the link at a constant posture, and also for this reason, the offset of the input current occurs.

If the input current which causes such an offset to occur is used for the estimation, the state observer in which the feedback gain matrix K is designed by the pole assignment estimates a torsion angle and a torsion angular velocity with a large error from the actual value, when the motor is stopped. That is, the estimation accuracy of the state observer falls when the motor is stopped.

If the estimation accuracy of the state observer falls when the motor is stopped, the torque compensation amount outputted from the torque compensation amount processor oscillates continuously when the motor is stopped, as illustrated in Fig. 7(a). Note that Fig. 7(a) illustrates a case where the feedback gain matrix K is designed so that the entire real part (A-KC) of the pole shown in Formula 10 becomes (-150).

As illustrated in Fig. 7(a), if it is considered that the torque compensation amount oscillates continuously, it is naturally impossible to set the gain of the torque compensation amount processor largely (if the gain is increased, the link will vibrate largely).

Therefore, the gain of the torque compensation amount processor is set small in consideration of the falling of the estimation accuracy of the state observer when the motor is stopped, which is caused by the offset of the input current when the motor is stopped.

Thus, in the state observer in the vibration-proof control, the feedback gain matrix K is designed so that the estimation accuracy of the state observer does not fall when the motor is stopped, even if the offset of the input current occurs when the motor is stopped (that is, the gain of the torque compensation amount processor is set largely), and all the plurality of transfer functions from the input current of each motor to the torsion angles and the torsion angular velocities of each of the plurality of spring elements have zero point at the origin.

In detail, in the case of the state observer of Fig. 5 corresponding to the 4-inertia model of Fig. 4, the feedback gain matrix K is designed so that all of the transfer function from the input current $I_1$ of the first motor to the torsion angle $\theta_{M1}$-$\theta_{L1}$ of the first spring element, the transfer function from the input current $I_1$ to the torsion angular velocity of the first spring element

$$\dot{\theta}_{M1} - \dot{\theta}_{L1},$$

the transfer function from the input current $I_1$ to the torsion angle $\theta_{M2}$-$\theta_{L2}$ of the second spring element, the transfer function from the input current $I_1$ to the torsion angular velocity of the second spring element

$$\dot{\theta}_{M2} - \dot{\theta}_{L2},$$

the transfer function from the input current $I_2$ of the second motor to the torsion angle $\theta_{M1}$-$\theta_{L1}$ of the first spring element, the transfer function from the input current $I_2$ to the torsion angular velocity of the first spring element

$$\dot{\theta}_{M1} - \dot{\theta}_{L1},$$

the transfer function from the input current $I_2$ to the torsion angle $\theta_{M2}$-$\theta_{L2}$ of the second spring element, and the transfer function from the input current $I_2$ to the torsion angular velocity of the second spring element

$$\dot{\theta}_{M2} - \dot{\theta}_{L2}$$

have the zero point at the origin. In other words, in all the eight transfer functions, the feedback gain matrix K is designed so that a coefficient of the $s°$ term (a term of the 0th power of the Laplace operator s) of the numerator becomes zero.

Such a design of the feedback gain matrix K is described concretely. Note that, here, in order to simplify the description, a 2-inertia model comprised of one link and one motor which drives the link is described as one example.

In the case of the 2-inertia model, the equation of state becomes as Formula 11, when the turning angle of the motor is $\theta_M$, the angle of the link is $\theta_L$, the inertia of the motor is $J_M$, the inertia of the link is $J_L$, the rigidity of the spring element between the motor and the link is $K_S$, and the attenuation of the spring element is $D_S$.

$$\dot{x} = Ax + Bu \qquad \dots(11)$$

$$x = \begin{bmatrix} \theta_M & \theta_M - \theta_L & \dot{\theta}_M & \dot{\theta}_M - \dot{\theta}_L \end{bmatrix}^T$$

$$A = \begin{bmatrix} 0 & 0 & 1 & 0 \\ 0 & 0 & 0 & 1 \\ 0 & -\dfrac{K_S}{J_M} & 0 & -\dfrac{D_S}{J_M} \\ 0 & -\dfrac{K_S}{J_M} - \dfrac{K_S}{J_L} & 0 & -\dfrac{D_S}{J_M} - \dfrac{D_S}{J_L} \end{bmatrix}$$

$$B = \begin{bmatrix} 0 \\ 0 \\ \dfrac{1}{J_M} \\ \dfrac{1}{J_M} \end{bmatrix}$$

Here, when the feedback gain matrix K is

$$K = \begin{bmatrix} K_1 & K_2 & K_3 & K_4 \end{bmatrix}^T,$$

and the turning angle of the motor is observable (that is,

$$C = \begin{bmatrix} 1 & 0 & 0 & 0 \end{bmatrix}$$

), the transfer function from the input current of the motor to the estimated value of the torsion angle $\theta_M$-$\theta_L$ of the spring element becomes as Formula 12. Moreover, the transfer function from the input current of the motor to the torsion angular velocity of the spring element

$$\dot{\theta}_M - \dot{\theta}_L$$

becomes as Formula 13. Note that the coefficients $a_0$ to $a_4$ in Formulas 12 and 13 become like those in Formula 14.

$$\frac{-J_L s^2 - (K_1 - K_2)J_L s + K_2 D_S - (K_3 - K_4)J_L}{a_4 s^4 + a_3 s^3 + a_2 s^2 + a_1 s + a_0} \qquad \ldots(12)$$

$$\frac{J_L s^3 - K_1 J_L s^2 - (K_3 - K_4)J_L s + K_2 K_S}{a_4 s^4 + a_3 s^3 + a_2 s^2 + a_1 s + a_0} \qquad \ldots(13)$$

$$a_4 = J_M J_L$$
$$a_3 = D_S(J_M + J_L) + K_1 J_M J_L$$
$$a_2 = K_S(J_M + J_L) + K_1 D_S(J_M + J_L) + K_3 J_M J_L$$
$$a_1 = K_1 K_S(J_M + J_L) - K_2 K_S J_L + K_3 D_S(J_M + J_L) - K_4 D_S J_L$$
$$a_0 = K_3 K_S(J_M + J_L) - K_4 K_S J_L \qquad \ldots(14)$$

In order for the two transfer functions shown in Formulas 12 and 13 to have the zero point at the origin, elements $K_1$ to $K_4$ of the feedback gain matrix K have to be determined as a value so that both a coefficient $K_2 D_S - (K_3 - K_4)J_L$ of the s° term of the numerator of Formula 12 and a coefficient $K_2 K_S$ of the S° term of the numerator of Formula 13 become zero.

Here, for example, the feedback gain matrix K is given as shown in Formula 15.

$$K = \alpha(\beta C^T + B) = \begin{bmatrix} \alpha\beta & 0 & \dfrac{\alpha}{J_M} & \dfrac{\alpha}{J_M} \end{bmatrix}^T \qquad \ldots(15)$$

In Formula 15, $\alpha$ and $\beta$ are adjustment parameters. If the feedback gain matrix K is designed like Formula 15, the coefficients of the s° terms of the numerators of the two transfer functions shown in Formulas 12 and 13 become zero, and the two transfer functions have the zero point at the origin. Note that, if not the turning angle of the motor but the rotation angular velocity is observable (that is,

$$C = \begin{bmatrix} 0 & 0 & 1 & 0 \end{bmatrix}$$

), the two transfer functions can similarly have the zero point at the origin when the adjustment parameter $\beta$ is zero.

If the transfer functions of Formulas 12 and 13 have the zero point at the origin, the occurrence of the continuous oscillation of the torque compensation amount can be suppressed when the motor is stopped, as illustrated in Fig. 7(b).

This is because, since a differentiation exists in the characteristic from the input current of the motor to the estimated value of the torsion angle and the estimated value of torsion angular velocity, the gain in the low frequency range falls and the gain becomes zero for a certain input value. Therefore, it becomes difficult for the state observer to be influenced by the offset of the input current, and it becomes difficult for the estimation accuracy to fall. As a result, when the motor is stopped, it becomes difficult for the torque compensation amount to have the continuous oscillation, and the gain of the torque compensation amount processor can be set largely.

Of course, the fact that, by the plurality of transfer functions from the input current of the motor to the torsion angle and the torsion angular velocity of the spring element having the zero point at the origin, the gain of the torque compensation amount processor can be set largely, is not limited to the 2-inertia model.

For example, when the first motor is stopped in the 4-inertia model of Fig. 4 (i.e., in the case of a 3-inertia model), the equation of state becomes as Formula 16.

$$\dot{x} = Ax + Bu \qquad \dots(16)$$

$$x = \begin{bmatrix} \theta_{M2} & -\theta_{L1} & \theta_{M2} - \theta_{L2} & \dot{\theta}_{M2} & -\dot{\theta}_{L1} & \dot{\theta}_{M2} - \dot{\theta}_{L2} \end{bmatrix}^T$$

$$u = u_2$$

$$A = \begin{bmatrix}
0 & 0 & 0 & 1 & 0 & 0 \\
0 & 0 & 0 & 0 & 1 & 0 \\
0 & 0 & 0 & 0 & 0 & 1 \\
0 & 0 & -K_{S2}\dfrac{1}{J_{M2}} & 0 & 0 & -D_{S2}\dfrac{1}{J_{M2}} \\
0 & -K_{S1}\dfrac{J_{L22}}{S} & -K_{S2}\dfrac{J_{L22}-J_{L12}}{S} & 0 & -D_{S1}\dfrac{J_{L22}}{S} & -D_{S2}\dfrac{J_{L22}-J_{L12}}{S} \\
0 & K_{S1}\dfrac{J_{L21}}{S} & -K_{S2}\dfrac{J_{M2}(J_{L11}+J_{M2}-J_{L21})+S}{J_{M2}S} & 0 & D_{S1}\dfrac{J_{L21}}{S} & -D_{S2}\dfrac{J_{M2}(J_{L11}+J_{M2}-J_{L21})+S}{J_{M2}S}
\end{bmatrix}$$

$$B = \begin{bmatrix}
0 \\
0 \\
0 \\
\dfrac{1}{J_{M2}} \\
\dfrac{J_{L22}}{S} \\
\dfrac{S - J_{M2}J_{L21}}{J_{M2}S}
\end{bmatrix}$$

$$S = (J_{L11} + J_{M2})J_{L22} - J_{L12}J_{L21}$$

Here, if the feedback gain matrix K is

$$K = \begin{bmatrix} K_1 & K_2 & K_3 & K_4 & K_5 & K_6 \end{bmatrix}^T$$

and the turning angle of the motor is observable, the coefficient of the s° term of the numerator of the transfer function from the input current of the second motor to the torsion angle $\theta_{M1}$-$\theta_{L1}$ of the first spring element becomes as Formula 17, the coefficient of the s° term of the numerator of the transfer function from the input current of the second motor to the torsion angle $\theta_{M2}$-$\theta_{L2}$ of the second spring element becomes as Formula 18, the coefficient of the s° term of the numerator of the transfer function from the input current of the second motor to the torsion angular velocity of the first spring element

$$\dot{\theta}_{M1} - \dot{\theta}_{L1}$$

becomes as Formula 19, the coefficient of the s° term of the resulting numerator of the transfer function from the input current of the second motor to the torsion angular velocity of the second spring element

$$\dot{\theta}_{M2} - \dot{\theta}_{L2}$$

becomes as Formula 20.

$$K_2 D_{S1} S - K_4 \left( J_{M2} + J_{L12} \right) S + K_5 \left( J_{M2} + J_{L11} \right) S + K_6 J_{L12} S$$

$$\ldots(17)$$

$$K_3 D_{S2} S - K_4 J_{L22} S + K_5 J_{L21} S + K_6 J_{L22} S \quad \ldots(18)$$

$$K_2 S \quad \ldots(19)$$

$$K_3 S \quad \ldots(20)$$

Here, for example, the feedback gain matrix K is given as shown in Formula 21.

$$K = \alpha \left( \beta C^T + B \right) = \begin{bmatrix} \alpha\beta & 0 & 0 & \dfrac{\alpha}{J_{M2}} & \dfrac{\alpha J_{L22}}{S} & \dfrac{\alpha\left(S - J_{M2}J_{L21}\right)}{J_{M2}S} \end{bmatrix}$$

$$\ldots(21)$$

In Formula 21, $\alpha$ and $\beta$ are adjustment parameters. If the feedback gain matrix K is designed like Formula 21, the transfer function from the input current of the second motor to the torsion angle $\theta_{M1}-\theta_{L1}$ of the first spring element, the transfer function from the input current of the second motor to the torsion angle $\theta_{M2}-\theta_{L2}$ of the second spring element, the transfer function from the input current of and the second motor to the torsion angular velocity of the first spring element

$$\dot{\theta}_{M1} - \dot{\theta}_{L1},$$

and the transfer function from the input current of the second motor to the torsion angular velocity of the second spring element

$$\dot{\theta}_{M2} - \dot{\theta}_{L2}$$

have the coefficients of the s° terms of the numerators of zero, and therefore, the four transfer functions have the zero point at the origin.

Moreover, also in the 4-inertia model illustrated in Fig. 4, if the back gain matrix K is designed like Formula 22, all the transfer function from the input current $I_1$ of the first motor to the torsion angle $\theta_{M1}-\theta_{L1}$ of the first spring element, the transfer function from the input current $I_1$ to the torsion angular velocity of the first spring element

$$\dot{\theta}_{M1} - \dot{\theta}_{L1},$$

the transfer function from the input current $I_1$ to the torsion angle $\theta_{M2}$-$\theta_{L2}$ of the second spring element, the transfer function from the input current $I_1$ to the torsion angular velocity of the second spring element

$$\dot{\theta}_{M2} - \dot{\theta}_{L2},$$

the transfer function from the input current $I_2$ of the second motor to the torsion angle $\theta_{M1}$-$\theta_{L1}$ of the first spring element, the transfer function from the input current $I_2$ to the torsion angular velocity of the first spring element

$$\dot{\theta}_{M1} - \dot{\theta}_{L1},$$

the transfer function from the input current $I_2$ to the torsion angle $\theta_{M2}$-$\theta_{L2}$ of the second spring element, and the transfer function from the input current $I_2$ to the torsion angular velocity of the second spring element

$$\dot{\theta}_{M2} - \dot{\theta}_{L2}$$

have the zero point at the origin.

$$K = \alpha\left(\beta C^T + B\right) = \begin{bmatrix} \alpha\beta & 0 \\ 0 & \alpha\beta \\ 0 & 0 \\ 0 & 0 \\ \dfrac{\alpha}{J_{M1}} & 0 \\ 0 & \dfrac{\alpha}{J_{M2}} \\ \dfrac{\alpha}{J_{M1}} & \dfrac{\alpha J_{L22}}{S} \\ 0 & \dfrac{\alpha\left(S - J_{M2}J_{L21}\right)}{J_{M2}S} \end{bmatrix} \quad \ldots(22)$$

As shown in Formulas 15, 21, and 22, the feedback gain matrix K which can set the gain of the torque compensation amount processor largely, regardless of the inertia model can be expressed by the following form.

$$K = \alpha\left(\beta C^T + B\right)$$

Therefore, the inertia model can be determined by identifying the stopped motor among the plurality of motors, and the feedback gain matrix K can be calculated from the matrixes B and C based on the determined inertia model.

[Operation]

Next, operation of the failure diagnosing device 1 configured as described above is described. Note that the operation of the failure diagnosing device 1 is also a method of diagnosing a failure according to this embodiment. In the work performed by the mechanical apparatus 11, the failure diagnosis of the drive mechanism 51 is conducted by selecting a timing at which it does not interfere with the work even if the vibration-proof control is not performed, and an acceleration and deceleration is accompanied. Such a timing includes a start or an end of the work. Here, a case where the failure diagnosis of the drive mechanism 51 is carried out at the start of the work is illustrated.

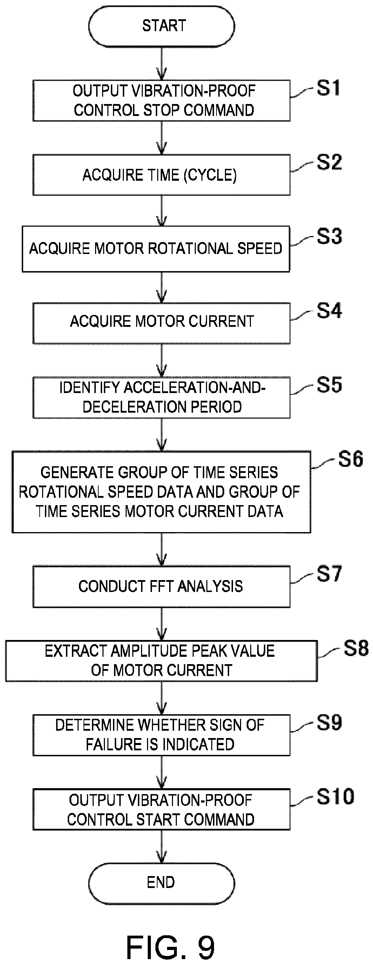

Fig. 9 is a flowchart illustrating the operation of the failure diagnosing device of Fig. 1.

Referring to Figs. 1, 2, and 9, the vibration-proof control stopping module 41 first outputs a vibration-proof control stop command to the vibration-proof controller 33 of the mechanical apparatus 11 (Step S1). If the vibration-proof controller 33 receives the vibration-proof control stop command, it suspends the vibration-proof control, and sends a signal indicative of the vibration-proof control being suspended to the motion controller 32. If the motion controller 32 receives this signal, it actuates the mechanical apparatus 11, and outputs an operation start signal to the vibration-proof control stopping module 41 of the failure diagnosing device 1. If the vibration-proof control stopping module 41 receives this operation start signal, it starts the failure diagnosis by each of the functional parts 2-9.

In this state, the failure diagnosing device 1 acquires a time (period or cycle) (Step S2).

Moreover, the rotational speed acquiring module 2 acquires a rotational speed of the motor 14 (Step S3).

Moreover, the motor current acquiring module 4 acquires a motor current of the motor 14 (Step S4).

Here, Step S2 (time acquisition), Step S3 (rotational speed acquisition), and Step S4 (motor current acquisition) may be interchanged in their order.

Next, the acceleration-and-deceleration period identifying module 3 identifies an acceleration-and-deceleration period based on the rotational speed of the motor acquired by the rotational speed acquiring module 2 (Step S5).

Then, the time series rotational speed data generating module 5 sequentially samples the rotational speed of the motor acquired by the rotational speed acquiring module 2 during the acceleration-and-deceleration period, and generates a group of time series rotational speed data. Moreover, the time series motor current data generating module 6 sequentially samples the motor current acquired by the motor current acquiring module 4 during the acceleration-and-deceleration period, and generates a group of time series motor current data (Step S6).

Here, the failure diagnosing device 1 determines the sampling frequency in advance. Moreover, it defines a sampling number of the motor per revolution.

Then, the FFT analyzing module 7 conducts a frequency analysis while corresponding the group of time series motor current data to the group of time series rotational speed data, and generates the frequency spectra 22 of the group of motor current data corresponding to the group of time series rotational speed data 21 (Step S7).

Then, the amplitude peak value extracting module 8 extracts the peak value 24 of the amplitude of the motor current in the given frequency range fr corresponding to the characteristic frequency f0 of the failure of the drive mechanism 51, from the frequency spectra 22 of the group of motor current data.

Next, the determining module 9 compares the extracted peak value 24 of the amplitude of the motor current with the given amplitude threshold, and based on this result, it determines whether the drive mechanism 51 indicates a sign of failure. In detail, if the peak value 24 of the amplitude of the motor current is above the given amplitude threshold, it determines that the drive mechanism 51 indicates a sign of the failure, and if the peak value 24 of the amplitude of the motor current is below the given amplitude threshold, it determines that the drive mechanism 51 does not indicate a sign of the failure.

Therefore, the determination of the failure indication is ended, and the vibration-proof control stopping module 41 transmits a vibration-proof control start command to the vibration-proof controller 33 of the mechanical apparatus 11 (Step S10). Then, in response to this vibration-proof control start command, the vibration-proof controller 33 starts the vibration-proof control, and ends the failure diagnosis.

Note that, when performing the failure diagnosis of the drive mechanism 51 during the work of the mechanical apparatus 11, if the vibration-proof control stop command is received from the vibration-proof control stopping module 41 at Step S1, the vibration-proof controller 33 suspends the vibration-proof control, and sends a signal indicative of the vibration-proof control being suspended to the vibration-proof control stopping module 41. In response to this signal, the vibration-proof control stopping module 41 starts the failure diagnosis by the functional parts 2-9. The subsequent processings are the same as the above.

[Experiment]

The present inventors confirmed, by the experiment, effects of the vibration-proof control to the value of the frequency component (the amplitude of the motor current) in the frequency spectra of the motor current.

In this experiment, an articulated robot is used as one example of the mechanical apparatus 11, and a normal (not failed) input gear of the speed reducer 13 of the robot body (robotic arm) as the body 31 is replaced by a broken (failed) input gear. Moreover, the robot controller as the controller 17 is configured to perform the vibration-proof control described above.

Then, a difference of the value of the frequency component (amplitude of the motor current) in the frequency spectra of the motor current in the state where the vibration-proof control is turned off, from the state where the vibration-proof control is turned on is calculated. This result is illustrated in Fig. 10.

Fig. 10 illustrates a graph illustrating a difference of the value of the frequency component (amplitude of the motor current) in the frequency spectra of the motor current in the state where the vibration-proof control is turned off, from the state where the vibration-proof control of the robot body is turned on.

In Fig. 10, the horizontal axis indicates a rotational speed (rpm) of the motor, the vertical axis indicates a frequency, and a gradation of the image indicates the difference (A) of the amplitude of the motor current (hereinafter, the difference of the motor current value). The difference of the motor current value is larger as the image becomes deeper (more black), and the difference of the motor current value is smaller as the image becomes lighter (more white). Moreover, a dotted line indicates a characteristic frequency of the broken input gear.

Referring to Fig. 10, an area where the difference of the motor current value has a positive value exists along the dotted line indicative of the characteristic frequency of the broken input gear, and the difference of the current value has a value of 0.08 to 0.12A particularly in an area where the frequency is 90 to 100 Hz and the rotational speed of the motor is near 1400rpm.

Therefore, from this experimental result, it can be seen that the value of the frequency component (amplitude of the motor current) in the frequency spectra of the motor current becomes larger in the state where the vibration-proof control of the robot body is turned off than the state where the vibration-proof control is turned on.

Note that the characteristic frequency of the failure differs depending on the element of the drive mechanism 51 and the mode of the failure. Although the characteristic frequency of the failure of Fig. 10 differs from the characteristic frequency of the failure of Figs. 3A and 3B, this is because the objects of the experiments differ.

[Operation and Effects]

As described above, according to this embodiment, during the acceleration-and-deceleration period of the mechanical apparatus 11, the current amplitude in the particular frequency range fr corresponding to the characteristic frequency f0 of the failure of the drive mechanism 51 increases by the resonance of the drive mechanism 51 and indicates the peak value 24, in the change in the frequency spectra S of the motor current with respect to the change in the rotational speed data R of the motor 14, and this peak value 24 has a correlation with a sign of the failure of the drive mechanism 51. Therefore, since it can be determined whether the drive mechanism 51 indicates a sign of a failure based on the change in the frequency spectra S of the motor current with respect to the change in the rotational speed data R of the motor 14, the failure diagnosis can be performed during the work of the mechanical apparatus 11 to which the speed reducer 13 is provided.

On the other hand, since this failure diagnosis utilizes the resonance of the drive mechanism 51, the peak value 24 in the frequency spectra S of the motor current becomes larger as the vibration of the body 31 becomes larger, and therefore, the accuracy (sensibility) of determining whether the drive mechanism 51 indicates a sign of failure improves. Therefore, like this embodiment, the failure of the drive mechanism 51 can be detected at an earlier stage upon the failure diagnosis by sending the command to the vibration-proof controller 33 of the mechanical apparatus 11 and suspending the vibration-proof control.

Note that, in the mechanical apparatus 11, since the operation which is accompanied by the acceleration and deceleration, and does not interfere with the work even if the vibration-proof control is suspended exists (for example, the start and the end of the work), it is possible to perform the failure diagnosis of the drive mechanism 51 during the work, while the vibration-proof control is suspended.

It is apparent for the person skilled in the art that many improvements and other embodiments of the present disclosure are possible from the above description. Therefore, the above description is to be interpreted only as illustration, and it is provided in order to teach the person skilled in the art the best mode that implements the present disclosure. The details of the structures and/or the functions may be changed substantially, without departing from the spirit of the present disclosure.

INDUSTRIAL APPLICABILITY

The failure diagnosing device for the drive mechanism of the present disclosure etc. is useful in the mechanical apparatus which carries out the vibration-proof control of the body, as the failure diagnosing device etc. for the drive mechanism which can detect the failure of the drive mechanism at an earlier stage.

DESCRIPTION OF REFERENCE CHARACTERS

| | |
|---|---|
| 1 | Failure Diagnosing Device |
| 2 | Rotational Speed Acquiring Module |
| 3 | Acceleration-and-deceleration Period Identifying Module |
| 4 | Motor Current Acquiring Module |
| 5 | Time Series Rotational Speed Data Generating Module |
| 6 | Time Series Motor Current Data Generating Module |
| 7 | FFT Analyzing Module |
| 8 | Amplitude Peak Value Extracting Module |
| 9 | Determining Module |
| 10 | Outputting Module |
| 11 | Mechanical Part |
| 12 | Operation Part |
| 13 | Speed Reducer |
| 13a | Output Shaft |
| 14 | Motor |
| 14a | Rotation Shaft |
| 15 | Power Converter |
| 16 | Encoder |
| 17 | Controller |
| 18 | Rotation Angle |
| 19 | Current |
| 20 | Current Command Value |
| 21 | Group of Time Series Rotational Speed Data |
| 22 | Frequency Spectra of Group of Time Series Motor Current Data |
| 31 | Body |
| 32 | Motion Controller |
| 33 | Vibration-proof Controller |
| 41 | Vibration-proof Control Stopping Module |
| 51 | Drive Mechanism |

**Claims**

1. A failure diagnosing device configured to diagnose a failure of a drive mechanism of a mechanical apparatus provided with:

   a body including a motor, a speed reducer configured to slow down rotational power of the motor, and an operation part configured to operate by the rotational power slowed down by the speed reducer; and
   a vibration-proof controller configured to perform a vibration-proof control to prevent vibration of the body, wherein the drive mechanism includes the motor and the speed reducer,
   wherein the failure diagnosing device sends a command for suspending the vibration-proof control to the vibration-proof controller of the mechanical apparatus, then identifies an acceleration-and-deceleration period during which operation of the mechanical apparatus of which the vibration-proof control is suspended accelerates and decelerates, and determines whether the drive mechanism indicates a sign of failure based on a change in a frequency spectrum of load current of the motor or a current value having a correlation with the load current (hereinafter, referred to as "the motor current") to a change in a rotational speed of the motor, during the acceleration-and-deceleration period.

2. The failure diagnosing device of claim 1, wherein the determination of whether the drive mechanism indicates the sign of failure is a determination of whether the speed reducer indicates a sign of failure.

3. The failure diagnosing device of claim 1, wherein the determination of whether the drive mechanism indicates the sign of failure is a determination of whether the motor indicates a sign of failure.

**4.** The failure diagnosing device of claim 1, comprising:

a rotational speed acquiring module configured to acquire the rotational speed of the motor;
an acceleration-and-deceleration period identifying module configured to identify the acceleration-and-deceleration period based on the rotational speed of the motor acquired by the rotational speed acquiring module;
a motor current acquiring module configured to acquire the motor current;
a time series rotational speed data generating module configured to sequentially sample the rotational speed of the motor acquired by the rotational speed acquiring module during the acceleration-and-deceleration period and generate a group of time series rotational speed data;
a time series motor current data generating module configured to sequentially sample the motor current acquired by the motor current acquiring module during the acceleration-and-deceleration period and generate a group of time series motor current data;
an FFT analyzing module configured to conduct a frequency analysis of the group of time series motor current data so as to correspond to the group of time series rotational speed data and generate frequency spectra of the group of motor current data corresponding to the group of time series rotational speed data;
an amplitude peak value extracting module configured to extract a peak value of the amplitude of the motor current in a given frequency range corresponding to a frequency characteristic to the failure of the drive mechanism, from the frequency spectra of the group of motor current data; and
a determining module configured to compare the extracted peak value of the amplitude of the motor current with a given amplitude threshold and determine whether the drive mechanism indicates the sign of failure based on the compared result.

**5.** The failure diagnosing device of any one of claims 1 to 4, comprising an output device configured to output the determined result.

**6.** The failure diagnosing device of any one of claims 1 to 5, wherein the mechanical apparatus is a robot and the body is a robot body.

**7.** A mechanical apparatus, comprising:

the failure diagnosing device of any one of claims 1 to 6;
a body including a motor, a speed reducer configured to slow down rotational power of the motor, and an operation part configured to operate by the rotational power slowed down by the speed reducer; and
a vibration-proof controller configured to perform a vibration-proof control to prevent vibration of the body, wherein the failure diagnosing device of the drive mechanism sends a command for suspending the vibration-proof control to the vibration-proof controller.

**8.** A method of diagnosing a failure of a drive mechanism of a mechanical apparatus provided with:

a body including a motor, a speed reducer configured to slow down rotational power of the motor, and an operation part configured to operate by the rotational power slowed down by the speed reducer; and
a vibration-proof controller configured to perform a vibration-proof control to prevent vibration of the body, wherein the drive mechanism includes the motor and the speed reducer,
the method comprising the steps of:

(a) causing the vibration-proof controller of the mechanical apparatus to suspend the vibration-proof control;
(b) then identifying an acceleration-and-deceleration period during which operation of the mechanical apparatus of which the vibration-proof control is suspended accelerates and decelerates; and
(c) determining whether the drive mechanism indicates a sign of failure based on a change in a frequency spectrum of load current of the motor or a current value having a correlation with the load current (hereinafter, referred to as "the motor current") to a change in a rotational speed of the motor, during the acceleration-and-deceleration period.

**9.** The method of claim 8, wherein (c) includes determining whether the speed reducer indicates a sign of failure.

**10.** The method of claim 8, wherein (c) includes determining whether the motor indicates a sign of failure.

**11.** The method of any one of claims 8 to 10, wherein

(b) includes:

acquiring the rotational speed of the motor; and
identifying the acceleration-and-deceleration period based on the acquired rotational speed of the motor;
wherein (c) includes:

acquiring the motor current;
sequentially sampling the acquired rotational speed of the motor during the acceleration-and-deceleration period and generating a group of time series rotational speed data;
sequentially sampling the acquired motor current during the acceleration-and-deceleration period and generating a group of time series motor current data;
conducting a frequency analysis of the group of time series motor current data so as to correspond to the group of time series rotational speed data and generating frequency spectra of the group of motor current data corresponding to the group of time series rotational speed data;
extracting a peak value of the amplitude of the motor current in a given frequency range corresponding to a frequency characteristic to the failure of the drive mechanism, from the frequency spectra of the group of motor current data; and
comparing the extracted peak value of the amplitude of the motor current with a given amplitude threshold and determining whether the drive mechanism indicates the sign of failure based on the compared result.

12. The method of any one of claims 8 to 11, further comprising outputting the determined result.

13. The method of any one of claims 8 to 12, wherein the mechanical apparatus is a robot and the body is a robot body.

FIG. 1

FIG. 2

FIG. 3A

FIG. 3B

2ND LINK

1ST LINK  2ND SPRING
ELEMENT

$\theta_{L2}$

$\theta_{L1}$

$K_{S2}, D_{S2}$

1ST SPRING
ELEMENT

$U_2$

2ND MOTOR

$K_{S1}, D_{S1}$

$\theta_{M2}$

$U_1$

1ST MOTOR

$\theta_{M1}$

4-INERTIA MODEL

# FIG. 4

FIG. 5

GAIN

FREQUENCY

4-INERTIA MODEL

( a )

GAIN

FREQUENCY

2-INERTIA MODEL

( b )

FIG. 6

START OF
STOP

CONNECTING
SIGNAL

DURING
OPERATION

DISPOSE ENTIRE POLE -150

( a )

START OF
STOP

DURING
OPERATION

DISPOSE ZERO POINT AT ORIGIN

( b )

FIG. 7

LINK

SPRING ELEMENT

LINK

TORSION
ANGLE

MOTOR

SPRING
ELEMENT

2-INERTIA MODEL

TORSION
ANGLE

MOTOR

LINK

2-INERTIA MODEL X N

FIG. 8

FIG. 9

FIG. 10

## INTERNATIONAL SEARCH REPORT

| International application No. |
| --- |
| PCT/JP2019/044377 |

**A. CLASSIFICATION OF SUBJECT MATTER**
Int.Cl. B25J19/06(2006.01)i, G01M13/02(2019.01)i, G01R31/34(2006.01)i

According to International Patent Classification (IPC) or to both national classification and IPC

**B. FIELDS SEARCHED**

Minimum documentation searched (classification system followed by classification symbols)
Int.Cl. B25J1/00-21/02, G01M13/00-13/045, G01R31/34

| Documentation searched other than minimum documentation to the extent that such documents are included in the fields searched | |
| --- | --- |
| Published examined utility model applications of Japan | 1922-1996 |
| Published unexamined utility model applications of Japan | 1971-2019 |
| Registered utility model specifications of Japan | 1996-2019 |
| Published registered utility model applications of Japan | 1994-2019 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2011-136391 A (KAWASAKI HEAVY INDUSTRIES, LTD.) 14 July 2011, entire text, all drawings (Family: none) | 1-13 |
| A | JP 2018-105782 A (KAWASAKI HEAVY INDUSTRIES, LTD.) 05 July 2018, entire text, all drawings & WO 2018/124182 A1 & KR 10-2019-0083648 A & CN 110139733 A | 1-13 |
| A | JP 5-297907 A (TSUBAKIMOTO CHAIN CO.) 12 November 1993, entire text, all drawings (Family: none) | 1-13 |

☒ Further documents are listed in the continuation of Box C.    ☐ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 17 December 2019 (17.12.2019) | 07 January 2020 (07.01.2020) |

| Name and mailing address of the ISA/ | Authorized officer |
| --- | --- |
| Japan Patent Office 3-4-3, Kasumigaseki, Chiyoda-ku, Tokyo 100-8915, Japan | |
| | Telephone No. |

Form PCT/ISA/210 (second sheet) (January 2015)

**INTERNATIONAL SEARCH REPORT**

International application No.

PCT/JP2019/044377

C (Continuation).   DOCUMENTS CONSIDERED TO BE RELEVANT

| Category* | Citation of document, with indication, where appropriate, of the relevant passages | Relevant to claim No. |
|---|---|---|
| A | JP 7-129251 A (YASKAWA ELECTRIC CORPORATION) 19 May 1995, entire text, all drawings (Family: none) | 1-13 |
| A | JP 2015-34776 A (KOBE STEEL, LTD.) 19 February 2015, entire text, all drawings (Family: none) | 1-13 |
| A | JP 2013-144325 A (SEIKO EPSON CORP.) 25 July 2013, entire text, all drawings (Family: none) | 1-13 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6144404 B

- JP 5411687 B